# EUROPEAN PATENT APPLICATION

(11) **EP 4 723 478 A1**
(43) Date of publication of application: **08.04.2026**
(21) Application number: 24810497.8
(22) Date of filing: 25.05.2024
(51) Int. Cl.: H03H 9/10, H03H 9/54, H03H 9/64

(54) **INTEGRATED FILTER PACKAGING STRUCTURE AND PACKAGING METHOD, AND MODULE AND ELECTRONIC PRODUCT**

(30) Priority: 25.05.2023 CN 202310600857
(71) Applicant: Vanchip (Tianjin) Technology Co. Ltd, Tianjin 300457 (CN)
(72) Inventor: JIANG, Pinfang, Tianjin 300457 (CN); ZHANG, Xinyao, Tianjin 300457 (CN); ZHANG, Lei, Tianjin 300457 (CN); XU, Xian, Tianjin 300457 (CN); LIN, Hongkuan, Tianjin 300457 (CN)
(74) Representative: Wang, Bo
(86) International application number: PCT/CN2024/095363
(87) International publication number: WO 2024/240262

(57) **Abstract**

Disclosed in the present invention are an integrated filter packaging structure and packaging method, and a module and an electronic product. The integrated filter packaging structure comprises a piezoelectric substrate, a plurality of die pads, an interdigital transducer, a side wall, a roof, a loaded layer and bumps, wherein the piezoelectric substrate is provided with a front face and a back face which are opposite each other; the die pads, the interdigital transducer and the side wall are all formed on the front face, and the die pads are arranged around the interdigital transducer; the roof, the piezoelectric substrate and the side wall jointly enclose a closed resonant cavity, and the interdigital transducer is located in the resonant cavity; the roof at least comprises a dielectric layer and a loaded layer which is electrically connected to the die pads by means of a redistribution layer or a metal column; and the bumps are electrically connected to the loaded layer by means of the redistribution layer or the metal column. In the present invention, a loaded layer is integrated with a roof structure of a filter, such that the size can be reduced and the roof structure can be enhanced, thereby improving the yield and the integration level.

## Description

### BACKGROUND

### Technical Field

The present invention relates to an integrated filter package structure, a method for packaging the integrated filter package structure, and a module and an electronic product that include the integrated filter package structure, and belongs to the field of semiconductor packaging technologies.

### Related Art

Currently, a package structure of an acoustic filter (for example, a filter having a resonant cavity like an SAW or a BAW) includes packaging forms such as a chip size packaging (CSP), a die-sized SAW packaging (DSSP), and a wafer level packaging (WLP). When the package structure is integrated into a module, some matching circuits need to be arranged on a base board of the module to perform matching, to form a complete circuit structure, thereby implementing a function of the module. However, because of a weak roof of a WLP package structure, a risk of collapsing easily occurs in a plastic packaging process, and it is difficult to ensure normal operation of the acoustic filter. In addition, currently, with a requirement for chip miniaturization, a mounting area on the base board is increasingly limited. How to implement a similar function while reducing the mounting area needed by the package structure becomes a direction of research in the industry.

### SUMMARY

A first technical problem to be resolved by the present invention is to provide an integrated filter package structure.

Another technical problem to be resolved by the present invention is to provide a method for packaging an integrated filter.

Still another technical problem to be resolved by the present invention is to provide a module including an integrated filter package structure.

Yet another technical problem to be resolved by the present invention is to provide an electronic product including an integrated filter package structure.

To achieve the foregoing technical objectives, the present invention provides the following technical solutions:
According to a first aspect of the embodiments of the present invention, an integrated filter package structure is provided, including a piezoelectric substrate, a plurality of die pads, an interdigital transducer, walls, a roof, a loaded layer, and bumps; where
the piezoelectric substrate has a front face and a rear face that are opposite to each other;
the die pads, the interdigital transducer, and the walls are all formed on the front face, and the die pads are arranged around the interdigital transducer; and
the roof, the piezoelectric substrate, and the walls jointly enclose a closed resonant cavity, and the interdigital transducer is in the resonant cavity; the roof comprises at least a dielectric layer and a loaded layer, and the loaded layer is electrically connected to the die pad through a redistribution layer or a metal rod; and the bump is electrically connected to the loaded layer through the redistribution layer or the metal rod.

Preferably, the dielectric layer of the roof includes at least a first layer and a second layer, and the loaded layer is sandwiched between the first layer and the second layer; or
the dielectric layer of the roof is at least one layer, and the loaded layer is on a surface of the roof.

Preferably, the redistribution layer is formed on an upper surface and an outer side of the dielectric layer, and is configured to connect the loaded layer to the die pad.

Preferably, the loaded layer is a passive device.

Preferably, the metal rod extends from the die pad, passes through the wall and the dielectric layer, and is exposed from the dielectric layer and connected to the solder ball.

According to a second aspect of the embodiments of the present invention, a method for packaging an integrated filter package structure is provided, including the following steps:
manufacturing a piezoelectric substrate of a filter, and forming die pads and an interdigital transducer on a front face;
coating the front face of the piezoelectric substrate with a polymer layer to cover the interdigital transducer and the die pads, to manufacture walls;
forming the polymer layer into the walls by photolithography development;
laminating a polymer layer on the walls, to form a resonant cavity;
forming a circuit pattern in a roof and removing a redundant material in the roof by the photolithography development, to expose a part of the wall and partially or completely bare the die pad;
performing sputtering or electroplating to form a loaded layer on the roof;
introducing the die pad on the piezoelectric substrate to a surface of the roof through a redistribution technology, and electrically connecting the die pad to the loaded layer;
performing balling on a surface that is of the redistribution layer and that is away from the piezoelectric substrate, to form a metal bump for an electrical connection to a base board.

Preferably, the dielectric layer of the roof includes a first layer and a second layer, and after the loaded layer is formed, the method further includes the following steps:
laminating a polymer layer on a surface of the first layer and the loaded layer to serve as a second layer of the roof; and
removing a redundant material of the second layer to form the roof.

Alternatively, the packaging method may include the following steps:
manufacturing a piezoelectric substrate of a filter, and forming die pads and an interdigital transducer on a front face;
coating the front face of the piezoelectric substrate with a polymer layer to cover the interdigital transducer and the die pads, to manufacture walls;
forming the polymer layer into the walls by photolithography development;
laminating a polymer layer on the walls, to form a resonant cavity;
removing a redundant material in a roof by the photolithography development, to expose a part of the wall and partially or completely bare the die pad;
performing sputtering or electroplating to form a loaded layer on the roof;
introducing the die pad on the piezoelectric substrate to a surface of the roof through a redistribution technology, and electrically connecting the die pad to the loaded layer;
removing redundant metal; and
performing balling on a surface that is of the redistribution layer and that is away from the piezoelectric substrate, to form a metal bump for an electrical connection to a base board.

Preferably, the step of performing sputtering or electroplating to form a loaded layer on the roof further includes forming a circuit pattern on the roof.

Preferably, the dielectric layer of the roof includes a first layer and a second layer, and after the loaded layer is formed, the method further includes the following steps:
laminating a polymer layer on a surface of the first layer and the loaded layer to serve as a second layer of the roof; and
removing a redundant material of the second layer to form the roof.

Alternatively, the packaging method may include the following steps:
manufacturing a piezoelectric substrate of a filter, and forming die pads and an interdigital transducer on a front face;
coating the front face of the piezoelectric substrate with a polymer layer to cover the interdigital transducer and the die pads, to manufacture walls;
forming the polymer layer into the walls by photolithography development, and expose the die pads from the walls;
laminating the roof and the walls together, to form a resonant cavity;
removing a redundant material in the roof by the photolithography development, to expose the die pad and form a through hole;
forming a metal seed layer by sputtering;
removing a redundant metal seed layer by etching, and reserving a metal seed layer on a surface of the through hole and a metal seed layer on a region that is of an upper surface of the roof and that is for forming the loaded layer;
filling up the through hole on the die pad to form a metal rod, and simultaneously forming the loaded layer on the region having the metal seed layer on the upper surface of the roof; and
performing balling on a surface that is of the metal rod and that is away from the piezoelectric substrate, to form a metal bump for an electrical connection to a base board.

Preferably, the step of removing a redundant material in the roof by the photolithography development further includes forming a circuit pattern in the roof.

According to a third aspect of the embodiments of the present invention, a module is provided, including the foregoing integrated filter package structure.

According to a fourth aspect of the embodiments of the present invention, an electronic product is provided, including the foregoing integrated filter package structure.

Compared with the related art, the present invention has the following technical characteristics. A matching circuit that needs to be distributed on a module base board is embedded in a roof or on a surface of a roof of a filter via a roof structure of the filter. In this way, a space requirement on the module base board is resolved without increasing a size of the filter. In addition, the matching circuit is manufactured on the roof of the filter through a redistribution technology, to enhance the roof structure to some extent, thereby avoiding collapsing of a resonant cavity caused by plastic packaging pressure in a subsequent plastic packaging process. Therefore, a yield of the filter and an integration level of circuit design are further improved.

### BRIEF DESCRIPTION OF THE DRAWINGS

FIG. 1A is a schematic diagram of an integrated filter package structure according to a first embodiment of the present invention;
FIG. 1B is a top view of the embodiment shown in FIG. 1A after a protection layer is removed;
FIG. 2 is a schematic diagram of distribution of integrated filter package structures according to a first embodiment of the present invention on a wafer;
FIG. 3A is a cross-section detailed view of an integrated filter package structure according to a first embodiment of the present invention;
FIG. 3B is a schematic diagram of an integrated filter package structure according to a second embodiment of the present invention;
FIG. 4A is a schematic diagram of a part of steps of a method for packaging an integrated filter package structure according to a first embodiment of the present invention;
FIG. 4B is a schematic diagram of another part of steps of the method for packaging an integrated filter package structure according to the first embodiment of the present invention;
FIG. 4C is a schematic diagram of still another part of steps of the method for packaging an integrated filter package structure according to the first embodiment of the present invention;
FIG. 5 is a schematic diagram of an integrated filter package structure according to a third embodiment of the present invention; and
FIG. 6 is a flowchart of a method for packaging an integrated filter package structure shown in FIG. 5.

### DETAILED DESCRIPTION

Technical content of the present invention is described in detail below with reference to drawings and specific embodiments.

Using a radio frequency power chip as an example, an output matching circuit of the radio frequency power chip is configured to convert a load resistance to an appropriate resistance needed by a power amplifier for operation, so that the power amplifier has best power and efficiency. Therefore, the matching circuit is crucial for performance of the power amplifier. Usually, a low quality coefficient (that is, a Q value) of an on-die matching component causes a large loss of the matching circuit. Therefore, the matching circuit is usually made as an off-die matching circuit. For example, the matching circuit may be formed into a chip through an integrated passive device (IPD) technology, and then integrated through a system in package (SiP) technology.

In the integrated filter package structure provided in embodiments of the present invention, a matching circuit chip or component is embedded into an integrated filter die, to form an embedded structure, thereby reducing a package size, increasing strength of a roof of the integrated filter die, and improving a yield.

### First embodiment:

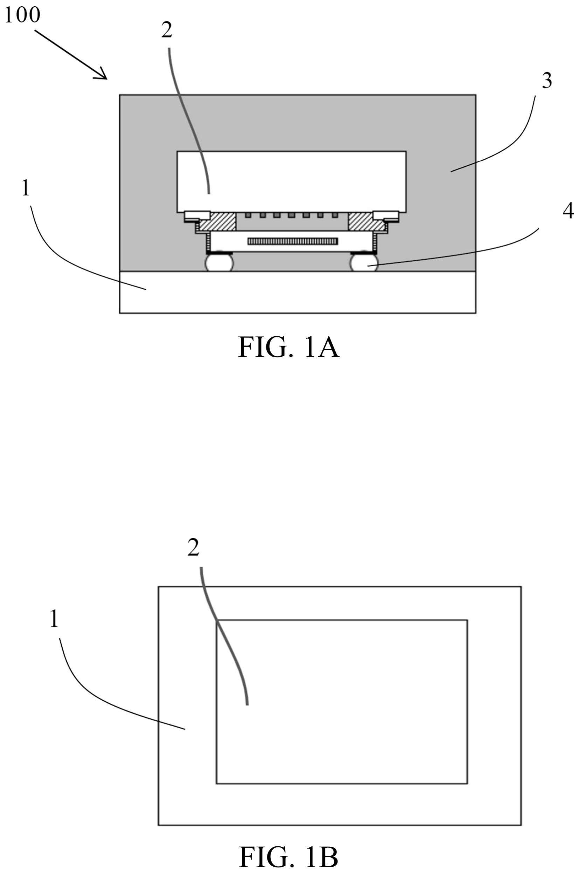

As shown in FIG. 1A and FIG. 1B, the first embodiment of the present invention discloses an integrated filter package structure 100, including a base board 1, at least one filter die 2 on the base board 1, and a plastic packaging layer 3. The filter die 2 is soldered onto the base board 1 through bumps 4, and the plastic packaging layer 3 is arranged on a piezoelectric substrate 11 and covers the filter die 2.

In an embodiment of the present invention, the integrated filter package structure 100 is described by using the filter die 2 as an example, but an implementation thereof is not limited to the filter die.

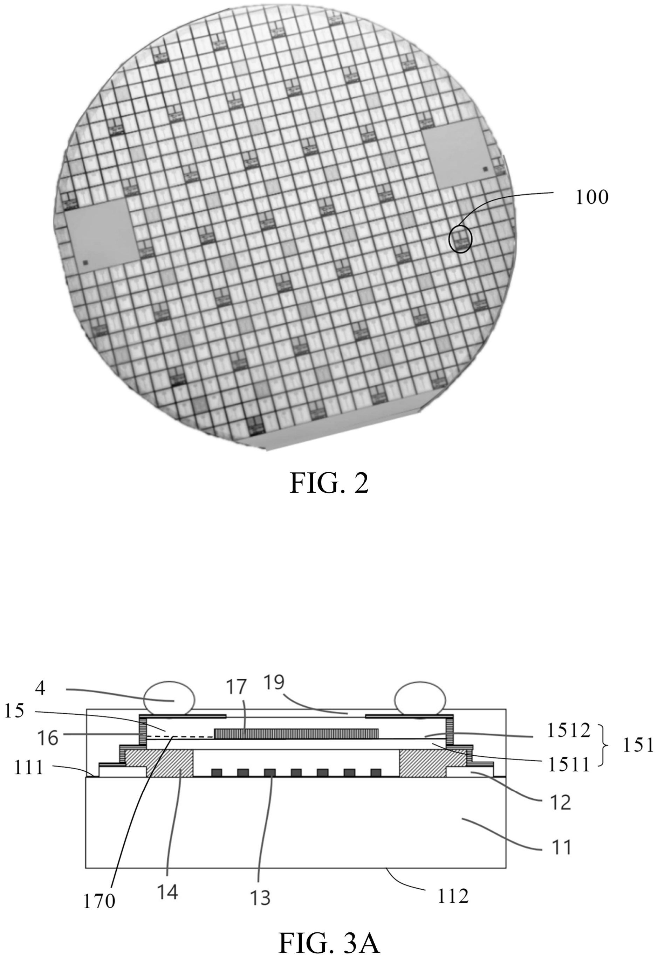

The foregoing integrated filter package structure is a wafer level package (WLP). As shown in FIG. 2, a plurality of integrated filter package structures 100 may be cut from one wafer.

As shown in FIG. 3A, the filter die 2 is a die, and includes a piezoelectric substrate 11, die pads 12, an interdigital transducer (IDT) 13, walls 14, a roof 15, a redistribution layer (RDL) 16, a loaded layer 17, and bumps 4.

The piezoelectric substrate 11 has a front face 111 and a rear face 112 that are opposite to each other. When the filter die 2 is soldered onto the base board 1 to form the integrated filter package structure 100, the front face 111 of the piezoelectric substrate 11 faces the base board 1.

The die pads 12, the interdigital transducer 13, and the walls 14 are all formed on the front face 111. The plurality of die pads 12 are arranged around the interdigital transducer 13. The walls 14 are inside the die pads 12, that is, in a region enclosed by the die pads 12. A thickness (that is, a size in a direction perpendicular to the die front face 111) of the wall 14 is greater than a thickness of the die pad 12. In addition, the wall 14 is between the die pad 12 and the interdigital transducer 13. In other words, an interdigital transducer region formed by the walls 14 surrounding the interdigital transducer 13 is smaller than a region enclosed by peripheries of the die pads 12. The interdigital transducer 13 is electrically connected to the die pad 12 through metal wiring.

The roof 15, the piezoelectric substrate 11, and the walls 14 jointly enclose a closed cavity (a resonant cavity), and the interdigital transducer 13 is in the resonant cavity. The roof 15 includes at least a dielectric layer 151 and a loaded layer 17. The dielectric layer may be made of a polymer material (for example, polyimide), to be reliably connected to the wall 14 through a laminating or adhesion process, and is applicable to being embedded in the loaded layer 17. The dielectric layer 151 may be a structure of one or more layers (for example, a structure of two layers, three layers, or more layers). In an embodiment of the present invention, the dielectric layer 151 includes a first layer 1511 and a second layer 1512 that are vertically stacked. During processing, the first layer 1511 is configured to carry the loaded layer 17, and the second layer 1512 is configured to cover the loaded layer 17. Preferably, the first layer 1511 and the second layer 1512 are made of a same polymer material (for example, a polyimide tape (PI tape), or a photoresist (PR tape). Alternatively, different materials may be selected. However, it needs to be ensured that the two materials have similar coefficients of thermal expansion (CTEs), and therefore cannot be delaminated.

That is, when the dielectric layer 151 has a two-layer structure, the loaded layer 17 is sandwiched between the first layer 1511 and the second layer 1512. In addition, a circuit 170 (shown by a dashed line in FIG. 3A) that is configured to be subsequently connected to the redistribution layer 16 is manufactured while a circuit pattern of the loaded layer 17 is manufactured on the PI tape, so that the redistribution layer 16 may be connected to the loaded layer 17 when the redistribution layer is formed by electroplating. In this embodiment shown in FIG. 3A, the loaded layer 17 is formed on the first layer 1511 by a process like sputtering, electroplating, or coating, and an end of the loaded layer 17 is exposed from a side face of the first layer 1511 and becomes the circuit 170 connected to the redistribution layer 16, to be electrically connected to the redistribution layer on the wall of the dielectric layer 151.

In an embodiment of the present invention, the loaded layer 17 is a wire wound inductor, but this does not constitute a limitation to the present invention. The loaded layer may alternatively be another passive device like a capacitor or a resistance.

The redistribution layer 16 spans between the roof 15 and the die pad 12, to electrically connect the loaded layer 17 to the die pad 12. The redistribution layer 16 is generated by a process like metal depositing, sputtering, or electroplating after the roof 15 is laminated to the wall 14, and is a metal layer added to an outside of the roof 15, the wall 14, and the die pad 12.

As shown in FIG. 3A, the redistribution layer 16 is electrically connected to the loaded layer 17, and extends from a top face of the roof 15 (which is a surface that is of the roof 15 and that is away from the piezoelectric substrate 11), to the wall 14 through a side face of the roof 15, and then to the die pad 12 to implement an electrical connection. In addition, the metal bump 4 is connected to the redistribution layer 16. The bumps 4, the redistribution layer 16, and the die pads 12 are all made of metal. Therefore, the loaded layer 17 is electrically connected to the base board 1 by using the redistribution layer 16, and the interdigital transducer 13 is also electrically connected to the base board 1.

More preferably, as shown in FIG. 3A, the roof 15, the wall 14, and the die pads 12 form a step structure. That is, the wall 14 is formed on an inner side that is of the die pad 12 and that faces the interdigital transducer region and a part of an upper surface that is of the die pad 12 and that faces the roof 15. At least a part of the die pad 12 needs to be exposed from the wall 14, to be electrically connected to the redistribution layer 16.

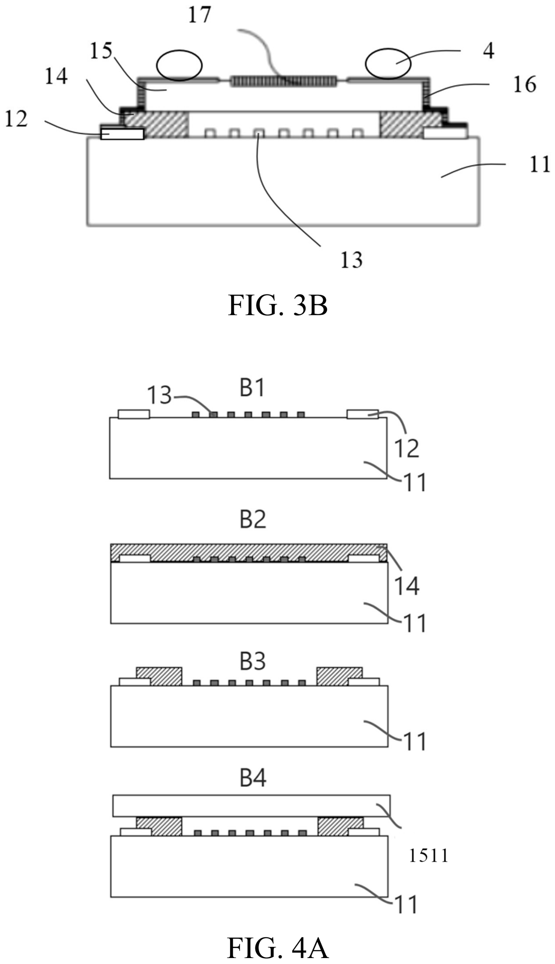

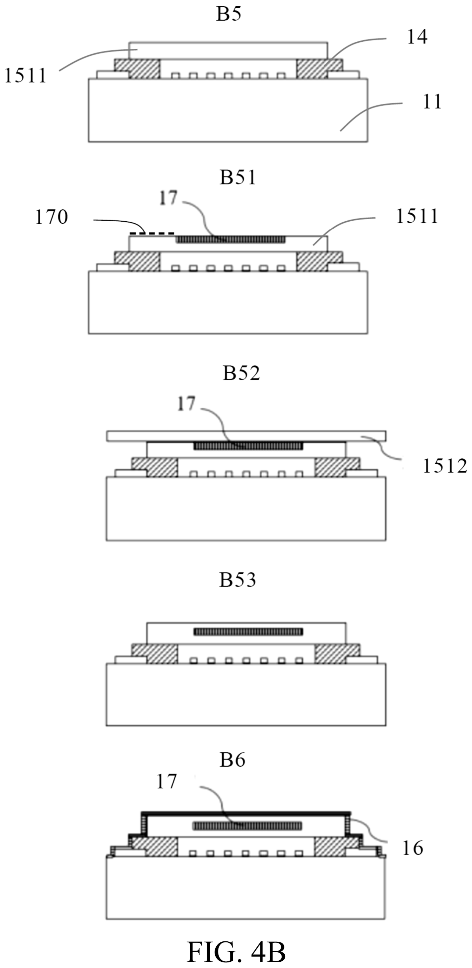

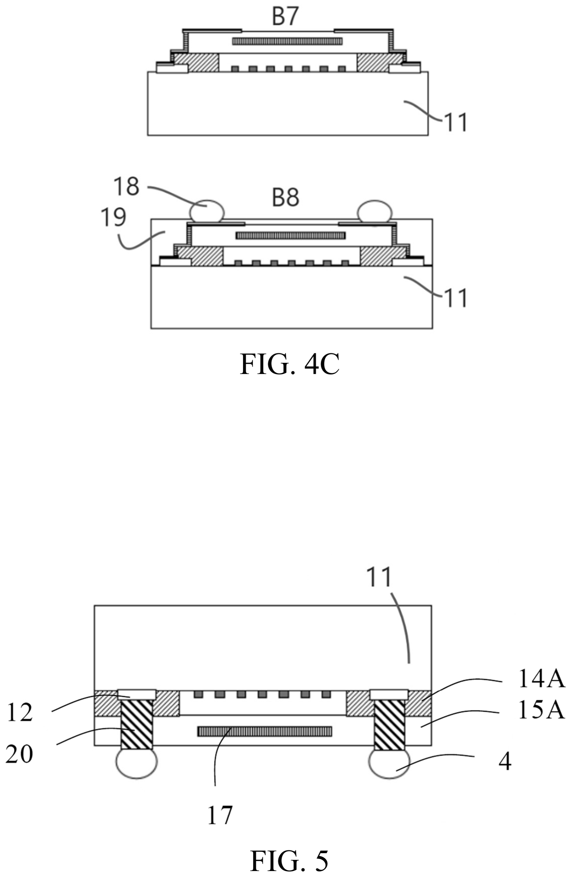

The following further describes, with reference to FIG. 4A, FIG. 4B, and FIG. 4C, a method for packaging the integrated filter package structure according to the first embodiment of the present invention. The packaging method includes at least the following steps.

B1: Manufacture a piezoelectric substrate 11 of a filter, and form die pads 12 and an interdigital transducer 13 on a front face.

This step is a common process, and therefore, is not described herein again.

B2: Coat the front face of the piezoelectric substrate 11 with a polymer layer to cover the interdigital transducer and the die pads, to manufacture walls.

The polymer may be a polyimide film, a photosensitive dry film, or the like. A thickness of the polymer layer is greater than a thickness of the die pad, and the polymer layer covers the interdigital transducer and the die pads. The thickness herein refers to a distance in a direction perpendicular to the front face. In an alternative solution, the polymer layer may also be laminated to the front face of the piezoelectric substrate 11 by a laminating process, to form the wall 14.

B3: Form the polymer layer into the walls 14 by photolithography development.

The polymer layer is solidified to form the walls 14 by the photolithography development, to surround the interdigital transducer 13 in an interdigital transducer region. A region enclosed by the walls 14 is the interdigital transducer region, that is, the walls 14 are on a periphery of the interdigital transducer region. The wall 14 is located on an inner side of the die pad 12 (which is a side that faces the interdigital transducer 13), and covers a part of the die pad 12, to form a step between an outer side of the wall 14 (which is a side that faces away from the interdigital transducer 13) and a surface of the die pad 12. In addition, the interdigital transducer 13 is exposed on the front face 111, and a polymer on a surface of the interdigital transducer 13 is removed.

B4: Laminate a polymer layer on the walls 14 to serve as the first layer 1511 of the roof 15, to form a resonant cavity.

The first layer 1511 of the roof 15 whose length is greater than a maximum distance between the walls 14 (for example, a projection region of the roof 15 on the piezoelectric substrate 11 is greater than a projection region of the walls 14 on the piezoelectric substrate 11) is laminated on the walls 14, so that the resonant cavity (cavity) is formed between the first layer 1511 of the roof 15, the walls 14, and the piezoelectric substrate 11, to protect the interdigital transducer 13 in the resonant cavity.

Preferably, the roof and the wall are made of the same material, to form a reliable connection.

B5: Remove a redundant material in the first layer 1511 of the roof 15 by the photolithography development, to expose a part of the wall 14 and partially or completely bare the die pad 12.

The redundant material in the first layer 1511 of the roof 15 is removed, so that a horizontal size of the first layer 1511 of the roof 15 (which is a distance in a direction parallel to the front face) is smaller than a horizontal size of the wall 14, to expose a part of a horizontal outer edge of the wall 14, so that metal cabling can be performed on the horizontal outer edge of the wall 14 when the redistribution layer 16 is subsequently manufactured. In this way, the step structure from the roof and the wall to the die pad may be formed. Specifically, multi-level steps are formed between an upper surface of the roof, an outer side of the roof, an upper surface of the wall, and an outer side of the wall to the upper surface of the die pad, to facilitate the metal cabling.

B51: Perform sputtering or electroplating on a surface of the first layer 1511 to form a loaded layer 17 and a circuit pattern.

In this step, a size of the first layer 1511 is made to be smaller than or equal to the region enclosed by the walls 14 in the previous step. Therefore, a size of the loaded layer 17 is smaller than the region enclosed by the walls 14, so that the loaded layer 17 may be completely covered in the roof 15 (or, completely between the first layer 1511 and a second layer 1512). In addition, a circuit 170 (shown by the dashed line in the figure) is exposed from an outer side face of the first layer 1511, and is configured to connect the loaded layer 17 to the redistribution layer 16.

It may be understood that, the circuit pattern may include the foregoing circuit 170, and may further include another circuit.

B52: Laminate a polymer layer on a surface of the first layer 1511 and the loaded layer 17 to serve as the second layer 1512 of the roof 15.

The second layer 1512 covering the loaded layer 17 is used to protect the loaded layer 17, and strengthen entire strength of the roof 15, to avoid collapsing.

B53: Form the circuit pattern on the surface, and remove a redundant material of the second layer 1512 to form the roof 15.

B6: Introduce the die pad 12 on the piezoelectric substrate 11 to a surface of the roof 15 through a redistribution technology, and electrically connect the die pad 12 to the loaded layer 17.

In this step, through the redistribution technology, a metal layer is formed as the redistribution layer on the multi-level steps between the upper surface of the roof, the outer side of the roof, the upper surface of the wall, and the outer side of the wall to the upper surface of the die pad, to introduce the die pad 12 on the piezoelectric substrate 11 to the upper surface of the roof 15.

Because the circuit 170 of the loaded layer 17 is exposed on the outer side face of the roof 15, when the redistribution layer 16 is manufactured, the redistribution layer 16 covering the outer side of the roof 15 may be connected to the circuit 170, to introduce the loaded layer 17 to the upper surface of the roof 15.

Because the roof 15 covers the redistribution layer 16, structural strength of the roof is further improved, to avoid collapsing of the resonant cavity caused by plastic packaging pressure in a subsequent plastic packaging process.

B7: Remove redundant metal.

B8: Perform balling on a surface that is of the redistribution layer 16 and that is away from the piezoelectric substrate, to form metal bumps 4 for an electrical connection to a base board.

Because the loaded layer 17 is connected to the redistribution layer 16 through the circuit 170 in the previous step, the redistribution layer 16 may be connected to the base board 1 through the bumps 4 in this step, thereby connecting the loaded layer 17 to the base board 1.

Optionally, the method further includes a step of covering the piezoelectric substrate with a protection layer 19. That is, a polymer (like polyimide) covers an outside of the redistribution layer through a plastic packaging process, to form the protection layer 19, to avoid that the redistribution layer 16 is damaged in subsequent processes such as filter transportation and encapsulation.

### Second embodiment:

In an alternative solution, as shown in FIG. 3B, a filter die 2 includes a piezoelectric substrate 11, die pads 12, an interdigital transducer 13, walls 14, a roof 15, a redistribution layer 16, a loaded layer 17, and bumps 4. The die pads 12, the interdigital transducer 13, and the walls 14 are all formed on a front face 111. The plurality of die pads 12 are arranged around the interdigital transducer 13. The wall 14 partially covers an upper surface of the die pad 12, and is arranged around the interdigital transducer 13. The roof 15 is laminated on the walls 14, to form a resonant cavity together with the walls 14 and the substrate 11. The loaded layer 17 is formed on an upper surface of the roof 15 (which is a surface away from the substrate), and is on the same layer as the redistribution layer 16 that is on the upper surface of the roof 15 and that is configured to be connected to the bumps 4. Therefore, the loaded layer is arranged on the upper surface of the roof 15, and may be directly and electrically connected to the redistribution layer 16 that is also on the upper surface.

B1: Manufacture a piezoelectric substrate 11 of a filter, and form die pads 12 and an interdigital transducer 13 on a front face.

B2: Coat the front face of the piezoelectric substrate 11 with a polymer layer to cover the interdigital transducer and the die pads, to manufacture walls.

B3: Form the polymer layer into the walls 14 by photolithography development.

B4: Laminate a polymer layer on the walls 14 to serve as a dielectric layer 151, to form a resonant cavity.

B5: Form a circuit pattern in a roof and remove a redundant material in the dielectric layer 151 by the photolithography development, to expose a part of the wall 14 and partially or completely bare the die pad 12 on the die.

It may be understood that, the circuit pattern may include the foregoing circuit 170, and may further include another circuit.

The foregoing steps B1 to B5 are in a one-to-one correspondence with the steps in the first embodiment, and details are not described herein again.

B50: Perform a process like sputtering, electroplating, or etching on an upper surface of the dielectric layer 151, to form and expose the loaded layer 17 from the dielectric layer 151, to form the roof 15.

The loaded layer 17 may be prepared by first coating the dielectric layer 151 with a layer of tape or a polymer, etching the polymer to develop a pattern of the loaded layer 17, and then forming a metal layer as the loaded layer 17 by electroplating or coating.

B6: Introduce the die pad 12 on the piezoelectric substrate 11 to a surface of the roof 15 through a redistribution technology, and electrically connect the die pad 12 to the loaded layer 17.

Different from the first embodiment, because the roof 15 has only one layer, the loaded layer 17 is formed on an upper surface of the roof 15, and is on a same surface as the redistribution layer 16. Therefore, the loaded layer 17 and the redistribution layer 16 may be directly connected to each other.

It can be known with reference to the first embodiment and the second embodiment that, because the integrated filter package structure provided in this embodiment of the present invention uses a WLP package instead of an SiP package, the loaded layer 17 may be electrically connected to the base board 1 through the redistribution layer 16, and the loaded layer 17 may be embedded in the roof 15 (that is, the loaded layer 17 is covered by the roof 15), or may be on the surface of the roof 15. Therefore, the loaded layer 17 no longer occupies a wiring area of the base board 1, and provides a larger design space for wiring of the base board. The loaded layer 17 being inside the roof 15 may increase mechanical strength of the roof 15, so that the roof 15 may bear large molding pressure in a plastic packaging process. In addition, the loaded layer 17 is electrically connected to lines on the base board 1, to function as a matching circuit.

### Third embodiment:

As shown in FIG. 5, this embodiment provides an integrated filter package structure in which a matching circuit (a loaded layer) is connected by using a metal rod. A difference from the first embodiment lies in that the integrated filter package structure does not have a redistribution layer, but uses a metal rod to electrically connect the loaded layer to a die pad. For packaging into a module, a bump on the metal rod is further used to electrically connect a filter to a base board.

Specifically, as shown in FIG. 5, a metal rod 20 is arranged on a front face of a die pad 12 (which is a surface away from a piezoelectric substrate), penetrates through a roof 15A, and extends out to a front face of the roof 15A to be connected to T, to electrically connect the die pad 12, wiring in the roof 15A, and a module base board 1 (not shown) together. A wall 14A completely covers the die pad 12, and covers a part of the metal rod 20, to provide a support force for the metal rod 20 and the die pad 12. The loaded layer 17 is electrically connected to the die pad 12 through the metal rod 20.

It should be noted that, a manufacturing mode of the roof 15A including the loaded layer 17 may be a manufacturing mode of a roof having two polymer layers (where the loaded layer 17 is inside the roof, as shown in FIG. 3A) in the first embodiment, or may be a manufacturing mode of a roof having only one layer of polymer (where the loaded layer 17 is on an upper surface of the roof, as shown in FIG. 3B) in the second embodiment. Details are not described herein again.

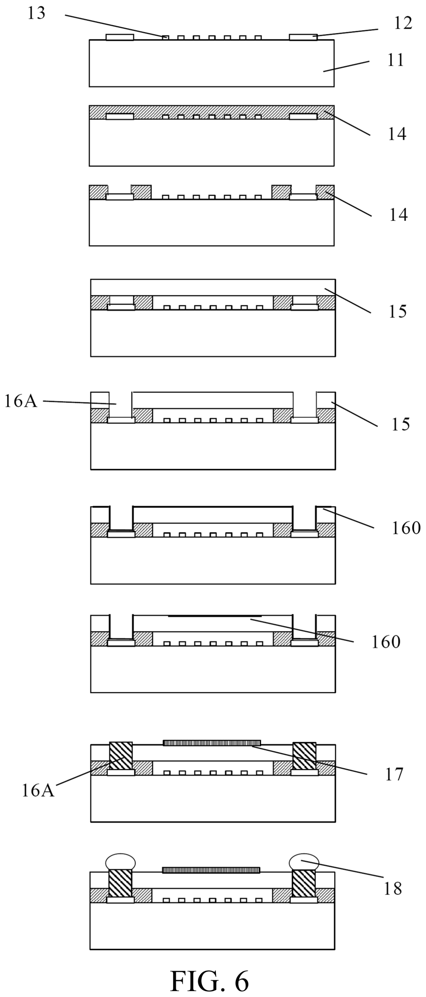

As shown in FIG. 6, the method for packaging the integrated filter provided in this embodiment of the present invention includes at least the following steps.

B1: Manufacture a piezoelectric substrate 11 of a filter, and form die pads 12 and an interdigital transducer 13 on a front face.

B2: Coat the front face of the piezoelectric substrate 11 with a layer of polymer to cover the interdigital transducer 13 and the die pads 12, to manufacture walls 14.

The polymer may be a polyimide film, a photosensitive dry film, or the like. A thickness of the polymer is greater than a thickness of the die pad 12. The thickness herein refers to a distance in a direction perpendicular to the front face.

B3: Form the walls 14 by photolithography development, and expose the die pads 12 on a die from the walls 14.

The polymer layer is solidified to form the walls 14 by the photolithography development, to protect the interdigital transducer in an interdigital transducer region. A region enclosed by the walls 14 is the interdigital transducer region, that is, the walls 14 are on a periphery of the interdigital transducer region. In addition, the interdigital transducer 13 is exposed from the polymer.

B4: Laminate the roof 15 and the walls 14 together, to form a resonant cavity.

The roof whose length is greater than a largest distance between the walls (for example, a projection on the piezoelectric substrate is greater than a projection of the walls on the piezoelectric substrate) is laminated to form the resonant cavity between the roof 15, the walls 14, and the piezoelectric substrate 11, to protect the interdigital transducer 13 in the resonant cavity.

In addition, because the length of the roof is greater than the largest distance between the walls, the roof 15 covers the walls and the die pads 12.

Preferably, the roof and the wall are made of the same material, to form a reliable connection.

B5: Form a circuit pattern in the roof and remove a redundant material in the roof 15 by the photolithography development, to expose the die pad 12 and form a through hole (which is alternatively referred as a channel 16A).

B6: Form a metal seed layer 160 by sputtering, to enhance a combination between the externally-introduced bump 4 and the die pad 12.

B7: Remove a redundant metal seed layer 160 by etching, and reserve a metal seed layer 160 on a surface of the through hole and a redundant metal seed layer 160 on a region that is of an upper surface of the roof and that is for forming the loaded layer 17.

B8: Fill up the through hole on the die pad 12 by a process like electroplating or sputtering to form a metal rod 16A, and simultaneously form the loaded layer 17 on the region having the metal seed layer 160 on the upper surface of the roof.

The loaded layer 17 comes into a connection with the metal rod on the upper surface of the roof. The through hole 16A is configured to connect the loaded layer 17 to the die pad 12, to be introduced to the base board 1.

B9: Perform balling on a surface that is of the metal rod 16A and that is away from the piezoelectric substrate 11, to form a metal bump 18 for an electrical connection to the base board 1.

Compared with the related art, according to the integrated filter package structure provided in this embodiment of the present invention, a matching circuit (that is, a loaded layer) that needs to be distributed on a module base board is embedded in a roof or on a surface of a roof of a filter via a roof structure of the filter. The loaded layer may be connected to the base board through a redistribution layer, or may be connected to the base board through a metal rod. Signal sources of the two connection manners are both a die pad on the die. In this way, a space requirement on the module base board is resolved without increasing a size of the filter. The matching circuit (that is, the loaded layer) that is manufactured on the roof on the filter strengthens the roof structure to some extent, thereby avoiding collapsing caused by plastic packaging pressure in a subsequent plastic packaging process. Therefore, the present invention further improves a yield of the filter and an integration level of circuit design.

On the basis of this, the present invention further provides a module, including the foregoing integrated filter package structure and another chip or discrete device. In addition, the present invention further provides an electronic product, including the foregoing integrated filter package structure and another module. The electronic product may be a wearable device, a communication terminal, an intelligent connected vehicle, or the like.

The integrated filter package structure, the packaging method, the module, and the electronic product provided in the present invention are described above in detail. A person of ordinary skill in the art making any apparent change made to the present invention without departing from the essential content of the present invention constitutes infringement to the patent right of the present invention, and should bear a corresponding legal liability.

## Claims

1. An integrated filter package structure, comprising a piezoelectric substrate, a plurality of die pads, an interdigital transducer, walls, a roof, a loaded layer, and bumps; wherein
the piezoelectric substrate has a front face and a rear face that are opposite to each other;
the die pads, the interdigital transducer, and the walls are all formed on the front face, and the die pads are arranged around the interdigital transducer; and
the roof, the piezoelectric substrate, and the walls jointly enclose a closed resonant cavity, and the interdigital transducer is in the resonant cavity; the roof comprises at least a dielectric layer and a loaded layer, and the loaded layer is electrically connected to the die pad through a redistribution layer or a metal rod; and the bump is electrically connected to the loaded layer through the redistribution layer or the metal rod.

2. The integrated filter package structure according to claim 1, wherein
the dielectric layer of the roof comprises at least a first layer and a second layer, and the loaded layer is sandwiched between the first layer and the second layer; or
the dielectric layer of the roof is at least one layer, and the loaded layer is on a surface of the roof.

3. The integrated filter package structure according to claim 2, wherein
the redistribution layer is formed on an upper surface and an outer side of the dielectric layer, and is configured to connect the loaded layer to the die pad.

4. The integrated filter package structure according to claim 3, wherein
the loaded layer is a passive device.

5. The integrated filter package structure according to claim 4, wherein
the metal rod extends from the die pad, passes through the wall and the dielectric layer, and is exposed from the dielectric layer and connected to the solder ball.

6. A method for packaging an integrated filter package structure, comprising the following steps:
manufacturing a piezoelectric substrate of a filter, and forming die pads and an interdigital transducer on a front face;
coating the front face of the piezoelectric substrate with a polymer layer to cover the interdigital transducer and the die pads, to manufacture walls;
forming the polymer layer into the walls by photolithography development;
laminating a polymer layer on the walls, to form a resonant cavity;
removing a redundant material in a roof by the photolithography development, to expose a part of the wall and partially or completely bare the die pad;
performing sputtering or electroplating to form a loaded layer on the roof;
introducing the die pad on the piezoelectric substrate to a surface of the roof through a redistribution technology, and electrically connecting the die pad to the loaded layer;
removing redundant metal; and
performing balling on a surface that is of the redistribution layer and that is away from the piezoelectric substrate, to form a metal bump for an electrical connection to a base board.

7. The method for packaging an integrated filter package structure according to claim 6, wherein the step of performing sputtering or electroplating to form a loaded layer on the roof further comprises forming a circuit pattern on the roof.

8. The method for packaging an integrated filter package structure according to claim 6, wherein the dielectric layer of the roof comprises a first layer and a second layer, and after the loaded layer is formed, the method further comprises the following steps:
laminating a polymer layer on a surface of the first layer and the loaded layer to serve as a second layer of the roof; and
removing a redundant material of the second layer to form the roof.

9. A method for packaging an integrated filter package structure, comprising the following steps:
manufacturing a piezoelectric substrate of a filter, and forming die pads and an interdigital transducer on a front face;
coating the front face of the piezoelectric substrate with a polymer layer to cover the interdigital transducer and the die pads, to manufacture walls;
forming the polymer layer into the walls by photolithography development, and expose the die pads from the walls;
laminating the roof and the walls together, to form a resonant cavity;
removing a redundant material in the roof by the photolithography development, to expose the die pad and form a through hole;
forming a metal seed layer by sputtering;
removing a redundant metal seed layer by etching, and reserving a metal seed layer on a surface of the through hole and a metal seed layer on a region that is of an upper surface of the roof and that is for forming the loaded layer;
filling up the through hole on the die pad to form a metal rod, and simultaneously forming the loaded layer on the region having the metal seed layer on the upper surface of the roof; and
performing balling on a surface that is of the metal rod and that is away from the piezoelectric substrate, to form a metal bump for an electrical connection to a base board.

10. The method for packaging an integrated filter package structure according to claim 9, wherein the step of removing a redundant material in the roof by the photolithography development further comprises forming a circuit pattern in the roof.

11. A module, comprising the integrated filter package structure according to any one of claims 1 to 5.

12. An electronic product, comprising the integrated filter package structure according to any one of claims 1 to 5.
